# EUROPEAN PATENT APPLICATION

(11) **EP 4 790 862 A1**
(43) Date of publication of application: **12.08.2026**
(21) Application number: 25157110.5
(22) Date of filing: 11.02.2025
(51) Int. Cl.: H02J 3/00, G06F 30/20

(54) **METHOD, DEVICE, SYSTEM AND STORAGE MEDIUM FOR OPTIMISATION OF A DYNAMIC BEHAVIOUR OF ONE OR MULTIPLE POWER-ELECTRONICS EQUIPMENT**

(71) Applicant: Hitachi Energy Ltd, 8050 Zürich (CH)
(72) Inventor: HUANG, Xing, Beijing, 100024 (CN); BOLZONI, Alberto, 5408 Ennetbaden (CH)
(74) Representative: Vossius & Partner Patentanwälte Rechtsanwälte mbB

(57) **Abstract**

The present disclosure relates to a method for optimisation of a dynamic behaviour of one or multiple power-electronics equipment. The method comprises providing a dynamic simulation model of a power-electronics equipment, obtaining an output of a real power-electronics equipment and an output of the dynamic simulation model, comparing the outputs of the real power-electronics equipment and the dynamic simulation model and adapting, depending on the comparison, parameters of the dynamic simulation model to a target dynamic behaviour of the power-electronics equipment.

## Description

The present disclosure relates to a method, device, system and storage medium for optimisation of a dynamic behaviour of one or multiple power-electronics equipment(s).

Along with the penetration of power equipment/assets such as converters in power system/power grid, stability of the grid is becoming challenging, leading to an increased importance of network management applications and their control functionalities. It is frequent that the assets (converters, active loads, local generators) connected to the network-management and supervision infrastructure come from different manufacturers which sometimes are different from the network management provider itself. Due to confidentiality issues, the network management architecture may not obtain all information necessary to adjust the dynamic behaviour of the assets as a function of the changing network needs. However, without a complete set of parameters, execution of stability analysis and real-time optimisation activities may be impeded.

There is thus a need for a grey-box parametric identification approach as well as for optimising converter dynamics with the objective to fit the requirements set by the network operator (transmission system operator (TSO) or distribution system operator (DSO)).

This need is met with the present disclosure.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for optimisation of a dynamic behaviour of one or multiple power-electronics equipment. The method comprises providing a dynamic simulation model of a power-electronics equipment, obtaining an output of a real power-electronics equipment and an output of the dynamic simulation model, comparing the outputs of the real power-electronics equipment and the dynamic simulation model and adapting, depending on the comparison, parameters of the dynamic simulation model to a target dynamic behaviour of the power-electronics equipment.

Various embodiments may preferably implement the following features.

Preferably, the target dynamic behaviour comprises a range of acceptable dynamic behaviour or a single reference trajectory.

Preferably, the adaptation is iteratively performed.

Preferably, the dynamic simulation model utilises a time domain simulation.

Preferably, the outputs comprise an operating point and a dynamic response to one or more planned and/or unplanned network events.

Preferably, the dynamic simulation model is based on an initial dynamic simulation model configured using known or default parameters of the power-electronics equipment.

Preferably, the dynamic simulation model is based on an initial dynamic simulation model configured using a default initial setting for the parameters and control / system topology of the power-electronics equipment.

Preferably, the method further comprises identifying and dynamically modelling of a power-electronics equipment connected to a power grid to obtain a dynamic simulation model of the power-electronics equipment.

Preferably, the method is performed by an external energy management system, EMS.

The present disclosure further relates to a device for optimisation of a dynamic behaviour of one or multiple power-electronics equipment. The device comprises at least one processor configured to provide a dynamic simulation model of a power-electronics equipment, obtain an output of a real power-electronics equipment and an output of the dynamic simulation model, compare the outputs of the real power-electronics equipment and the dynamic simulation model and adapt, depending on the comparison, parameters of the dynamic simulation model to a target dynamic behaviour of the power-electronics equipment.

Various embodiments may preferably implement the following features.

Preferably, the at least one processor is further configured to implement the method outlined above.

The present disclosure further relates to a system comprising the device outlined above.

The present disclosure further relates to a non-volatile storage medium comprising instructions which, when executed by a processor, configure the processor to implement the method as outlined above.

The present disclosure further relates to a computer program product comprising instructions which, when executed by a processor, configure the processor to implement the method as outlined above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.
Fig. 1 shows a flow chart of a method for optimisation of dynamics according to an embodiment of the present disclosure.
Fig. 2 shows a flow chart of an asset identification and optimisation of dynamics according to an embodiment of the present disclosure.
Fig. 3 shows a block diagram of an asset identification according to an embodiment of the present disclosure.
Fig. 4 shows a flow chart of asset identification and optimisation of dynamics according to an embodiment of the present disclosure.

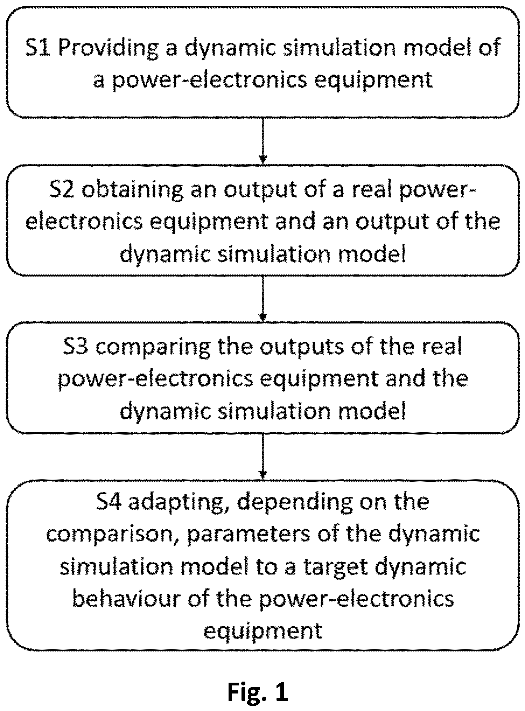

Fig. 1 shows a flow chart of a method according to an embodiment of the present disclosure.

The method for optimisation of a dynamic behaviour of one or multiple power-electronics equipment comprises providing (S1) a dynamic simulation model of a power-electronics equipment, obtaining (S2) an output of a real power-electronics equipment and an output of the dynamic simulation model, comparing (S3) the outputs of the real power-electronics equipment and the dynamic simulation model and adapting (S4), depending on the comparison, parameters of the dynamic simulation model to a target dynamic behaviour of the power-electronics equipment.

That is, the dynamic simulation model may be subjected to the same dynamic input (external disturbance or actuation command) as the real power electronics equipment in step S2. Subsequently, the outputs of the real power-electronics equipment and the dynamic simulation model subjected to the same dynamic input may be compared in step S3.

As used herein, the term dynamic behaviour may indicate a response to an event in the network/power grid. In particular, it may indicate a shape of an evolution of state variables within the power electronic equipment as a response to a planned / unplanned external event in the network or to a change in one of the reference quantities of the control system. In mathematical terms, the dynamic behaviour may be affected by a set of non-linear differential equations of the power electronics asset.

An unplanned event may refer to faults, connection, disconnection of units, over / under-voltages due to resonance conditions, unplanned reconfigurations of the network topology, etc.

Planned network events may be energization routines, connection / disconnection of units, planned reconfigurations of the network topology.

Dynamic simulation model may refer to a digital description of the dynamic behaviour of the power electronics equipment, capable of predicting the characteristics of its transient behaviour under a general variation of the external network or of the reference quantities within the control.

Target dynamic behaviour may refer to a reference shape of the dynamic behaviour defined within the network energy management architecture. Different from state-of-the-art steady-state optimisation, not only the initial / final operating points are subjected to the optimisation process, but also the shape of the time-domain transient through which the power-electronics asset evolves toward the new operating point (e.g., the speed of the change, the presence or absence of overshoot behaviour, ...).

Real values may refer to values measured in real-time from the field through standardised electrical measurements procedures or derived through SCADA datasets.

An energy management system (EMS) is a supervisory control architecture used to coordinate the electrical behaviour of one or multiple assets. It may control a static behaviour of the power-electronics equipment or, as used herein, it may also account for the dynamic behaviour.

In an embodiment, the target dynamic behaviour comprises a range of acceptable dynamic behaviour or a single reference trajectory.

That is, the target dynamic behaviour may comprise a target line (trajectory) of a response for any electrical quantity (voltage, current, active / reactive power, electrical frequency).

The dynamic model is adapted to correspond as close as possible to the target line

In an embodiment, the adaptation is iteratively performed.

In an embodiment, the dynamic simulation model utilises a time domain simulation.

In an embodiment, the outputs comprise an operating point and a dynamic response to one or more planned and/or unplanned network events.

In an embodiment, the dynamic simulation model is based on an initial dynamic simulation model configured using known parameters of the power-electronics equipment. Thus, not all parameters need to be known for the model to correctly simulate the real power equipment. In particular, the dynamic simulation model may be based on an initial dynamic simulation model configured using a default initial setting for the parameters and a control / system topology of the power-electronics equipment.

In an embodiment, the method further comprises identifying and dynamically modelling of a power-electronics equipment connected to a power grid to obtain a dynamic simulation model of the power-electronics equipment.

This automatic identification of new equipment allows to extract the dynamic characteristics of the real power asset (either in the time-domain or frequency-domain) through a set of measurements routines. This enables the exploitation of the dynamic adaptation process (claim 1) also for those assets whose dynamic characterisation is initially unknown.

In an embodiment, the method is performed by an external energy management system, EMS.

The present disclosure also relates to a device for optimisation of a dynamic behaviour of one or multiple power-electronics equipment. The device comprises at least one processor configured to provide a dynamic simulation model of a power-electronics equipment, obtain an output of a real power-electronics equipment and an output of the dynamic simulation model, compare the outputs of the real power-electronics equipment and the dynamic simulation model and adapt, depending on the comparison, parameters of the dynamic simulation model to a target dynamic behaviour of the power-electronics equipment.

In an embodiment, the at least one processor is further configured to implement the method as outlined above.

The present disclosure further relates to a system comprising the device outlined above and a power-electronics equipment.

Moreover, the present disclosure relates to a non-volatile storage medium comprising instructions which, when executed by a processor, configure the processor to implement the method described above.

The present disclosure also relates to a computer program product comprising instructions which, when executed by a processor, configure the processor to implement the method described above.

The above optimisation will now be described in further detail which is fully compatible with the embodiments outlined above.

The optimisation of dynamics, i.e., optimisation of dynamic behaviour relates to a process of adjustment and optimisation of a future expected dynamic behaviour of the power converter, wherein the dynamic (transient) response of the converter is triggered by an unplanned network event (e.g., external fault, disconnection of a nearby unit...). The optimiser may adapt (periodically, on-demand or triggered by a detected change in the network) control parameters of one or multiple power converters in the plant, such that the expected dynamic (transient) behaviour of the whole system is compliant with the time-changing dynamic targets set by the operator of the local network (public or private) and with the time-changing status of the network itself.

Compared to state-of the art operations of the energy management system, the present disclosure, rather than focusing only on the slow steady-state operations within the optimisation problem (static operating point), the disclosed optimisation of dynamics is based on the shape of the transient operations of the system.

That is, the present disclosure relates to an application of the above optimisation of dynamics concept within energy management systems for power networks.

Moreover, the optimisation of dynamics concept can be combined with suitable routines for the identification of unknown assets as will be further described below.

The present disclosure also relates to a combination of the optimisation of dynamics and identification process within real operating routines operated within the energy management systems for power networks.

In an embodiment, an initialisation process of the optimisation of dynamics may comprise the following. A dynamic simulation model of a power-electronics equipment (e.g., a converter simulation model; in the following, it will exemplarily be referred to a converter) is provided/designed and linked to the optimisation tool (optimisation method). Disturbance on a power grid voltage as well as requirements on a converter dynamic response performance are defined and saved. Converter dynamic response signals are set as outputs in the dynamic simulation model and the outputs are linked to the optimisation tool.

Subsequently, the converter simulation model is run. The simulation may particularly be run in the time-domain. The resulting converter output waveforms are sent to an optimisation solver (for adapting the parameters of the dynamic simulation model). The optimisation solver calculates an error between defined requirements of the converter dynamic response (performance) and the obtained converter output simulation results.

In case the requirements are met, i.e., the converter dynamic response corresponds to a desired dynamic response, the optimisation results are saved with the respective parameters.

In case the requirements are not met, it is checked whether the optimisation has been performed a maximum number of iterations and, in the affirmative, the optimisation results are saved with the respective parameters.

In case the maximum number of iterations is not yet achieved, the optimisation tool will optimise the selected parameters based on the calculated error between the defined requirements on the converter dynamic response and the converter output simulation results.

The defined requirements may be a line or an acceptable range of values, e.g., a range of values above and below the line. The line may refer to a power equipment parameter such as a current and/or a voltage over time.

As noted above, according to an embodiment, the present disclosure relates to an integration of identification and dynamic optimisation (i.e., optimisation of a dynamic behaviour) functionalities for power electronics equipment (assets/converters) in a network management system of both private or public distribution networks, operated in parallel to the mains of an external grid (grid-connected mode) or in island.

Furthermore, part of the active assets in the network may be from multiple manufactures. Since certain or all parameters of the assets may not be known, these assets may be modelled as grey-box elements within the network management architecture.

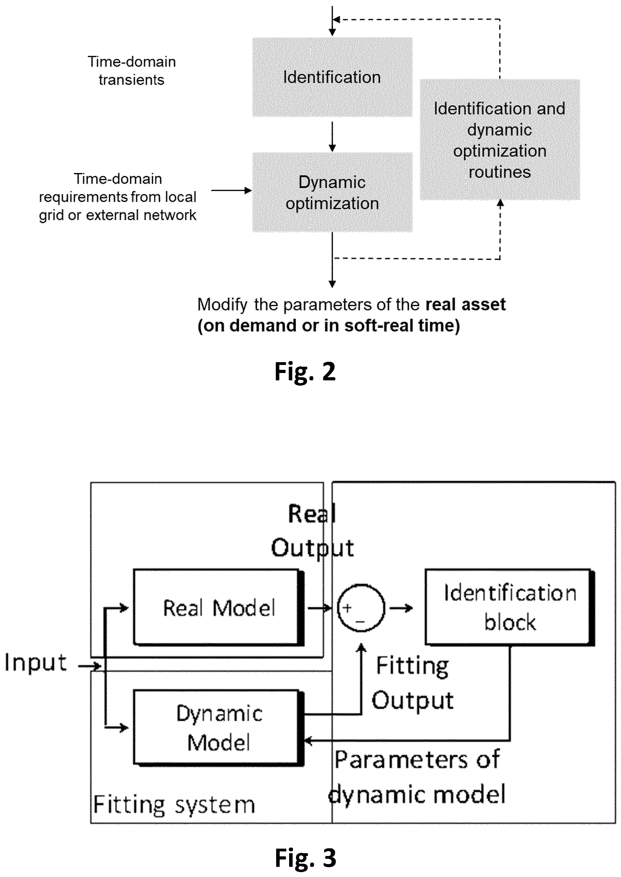

Thus, the present disclosure relates to a method or an intelligent assistant for network management and microgrid control. This method may operate, in addition to the dynamic optimisation method outlined above, according to iterative repetition of the identification and dynamic optimisation routines. This is shown in the flow chart of Fig. 2.

In particular, in case a new, unknown asset is connected to the power grid, an identification routine is performed for determining missing parameters of the asset and providing these parameters to a dynamic simulation model. This may be performed in the time-domain, i.e., based on time-domain transients. Subsequently, the dynamic optimisation (optimisation of dynamics, see above) and, if necessary, parameters of the real asset are modified.

Fig. 3 shows a simplified version of an asset identification. At the initial point, with the same input signals, the output signals of the dynamic model may not be the same as the output signals of real model. Based on the comparison results, the identification block will modify the parameters of the dynamic model, until the output signals of dynamic model and real model match each other. As all the simulations may be performed in the time-domain, the simulation model is capable of including non-linear characteristics. It may thus be capable of correctly representing the physical non-linear nature of the real set-up. This gives the further advantage of more accurately simulate and adapt the asset.

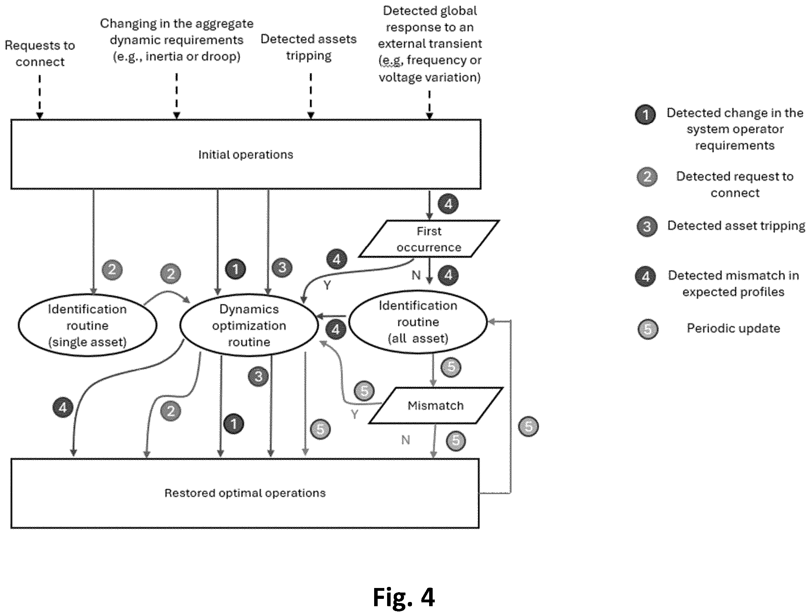

The identification and dynamic optimisation routines can be launched either manually, as a function of an external trigger or in in automated form (periodically), even with different periodicity of the identification and dynamic optimisation routines themselves. An example of algorithmic executions of these routines is shown in Fig. 4.

Fig. 4 is a flow chart indicating the operations depending on certain events. As indicated by the numbers, the process flow is shown for (1) a detected change in the system operator requirements (e.g., an external control signal), (2) a detected request to connect (an additional asset), (3) a detected asset tripping, (4) a detected mismatch in expected profiles, and (5) a periodic update. "Y" indicates that the enquiry is answered with "Yes", while "N" indicates that the enquiry is answered with "No".

The "identification routine" corresponds to the asset identification outlined above (see also Figs. 2 and 3) while the "dynamics optimisation routine" corresponds to the optimisation of dynamics described above (see also Figs. 1 and 2).

In summary, limitations of existing solutions include a lack of structured coordination between the asset identification / asset optimisation routines in most of the network management and microgrid architectures.

Moreover, the prior art fails to account for a non-linear converter in real applications.

To use the modern control theories for stability analysis and performance optimisation, normally the converters are simplified into linear model. This simplification introduces errors, because the influence of non-linear elements in converter are ignored, i.e., the limiters, digital time delay, PWM in converters, etc. In real applications, these non-linear elements in converters have a big influence on the converter dynamics and stability performance. The proposed approach holds both for linear and non-linear models.

The prior art systems also fail to account for a continuously upgraded system.

Along with the penetration of converters, the power network is growing fast in recent years: more and more new converters (PV converter, wind converter, EV chargers, battery energy storage converters, etc.) or loads are connected into the network. Furthermore, the controllers of existed converters are also updated into new versions with more functionality or better performance. If the network controller is not updated according to these system changes, the network management performance will be significantly influenced.

According to the present disclosure, a controller functionality in a grid with multiple assets is presented for optimisation of a dynamic response. This secondary controller (device) may also include two routines described above: (a) asset dynamics identification, and (b) dynamic optimisation of the assets installed in the network.

The secondary controller may be installed in the local network controller and aims at optimising the coordinated behaviour of one or multiple assets. The microgrid can operate both islanded mode and in grid-connected mode. The local network includes at least one or more assets, which are known to the local network controller in terms of their overall hardware / control topology, but unknown concerning the specific physical or control parameters (grey box). The repetition pattern between identification and optimisation routines can be selected depending on the desired level of responsiveness of the full architecture.

Further, the present disclosure utilises a time domain simulation solution.

Considering the converters in real applications are non-linear, this disclosure uses time domain simulations and underlying support for the in-field identification routine. In this case, the dynamic model of the non-linear converters can be obtained during the converter identification stage starting from a reduced set of triggered transients' operations on the single assets.

Hence, the time-domain simulation may ensure more accurate simulation results due to the lack of assumptions/simplification and possibility to account for the non-linear characteristics.

Furthermore, the models may be periodically and autonomously updated through self-inspection.

The power network may grow with more converters installed and the installed converters may be updated with new converter controllers or control functions. The presented method is able to periodically perform converter identification and adapt the dynamic models accordingly. Thus, the dynamic models for the adaptation process can be regularly updated.

The present disclosure is capable of controlling a dynamic response of a power equipment/asset based on a dynamic model. Thus, not only a static problem (only based on operating point) is solved but the complete dynamic response is adapted according to the requirements.

The adaptation may be carried out through a numeric optimisation algorithm.

The adapted behaviour may be the one that maximises the positive impact of the power equipment on the electrical network, compatibly with its physical operating constraints.

As an alternative to the above-mentioned procedure in the time-domain, the process can be expressed in the frequency-domain. This may comprise providing a dynamic model of a power electronics equipment, obtaining frequency-domain characterisation of the real equipment and the dynamic model, comparing the frequency domain characterisation of the real equipment and the dynamic model and adapting, depending on the comparison, parameters of the dynamic model to a target frequency-domain characterisation.

Therein, the target dynamic behaviour can be expressed by a reference frequency domain function or by a range of acceptable frequency domain characterisations.

Aside for the exploitation in real power networks, the approach can be deployed within software environments for power network simulation (e.g., for the integration on masked / black box / compiled models in a simulation set-up).

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organisation.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. Method for optimisation of a dynamic behaviour of one or multiple power-electronics equipment, the method comprising:
providing a dynamic simulation model of a power-electronics equipment;
obtaining an output of a real power-electronics equipment and an output of the dynamic simulation model;
comparing the outputs of the real power-electronics equipment and the dynamic simulation model; and
adapting, depending on the comparison, parameters of the dynamic simulation model to a target dynamic behaviour of the power-electronics equipment.

2. Method according to claim 1, wherein the target dynamic behaviour comprises a range of acceptable dynamic behaviour or a single reference trajectory.

3. Method according to claim 1 or 2, wherein the adaptation is iteratively performed.

4. Method according to any one of claims 1 to 3, wherein the dynamic simulation model utilises a time domain simulation.

5. Method according to any one of claims 1 to 4, wherein the outputs comprise an operating point and a dynamic response to one or more planned and/or unplanned network events.

6. Method according to any one of claims 1 to 5, wherein the dynamic simulation model is based on an initial dynamic simulation model configured using known or default parameters of the power-electronics equipment.

7. Method according to any one of claims 1 to 6, wherein the method further comprises identifying and dynamically modelling of a power-electronics equipment connected to a power grid to obtain a dynamic simulation model of the power-electronics equipment.

8. Method according to any one of claims 1 to 7, wherein the method is performed by an external energy management system, EMS.

9. Device for optimisation of a dynamic behaviour of one or multiple power-electronics equipment, the device comprising at least one processor configured to:
provide a dynamic simulation model of a power-electronics equipment;
obtain an output of a real power-electronics equipment and an output of the dynamic simulation model;
compare the outputs of the real power-electronics equipment and the dynamic simulation model; and
adapt, depending on the comparison, parameters of the dynamic simulation model to a target dynamic behaviour of the power-electronics equipment.

10. Device according to claim 9, wherein the at least one processor is further configured to implement the method according to any one of claims 2 to 8.

11. System comprising the device according to claim 9 or 10, and a power-electronics equipment.

12. Non-volatile storage medium comprising instructions which, when executed by a processor, configure the processor to implement the method according to any one of claims 1 to 8.

13. Computer program product comprising instructions which, when executed by a processor, configure the processor to implement the method according to any one of claims 1 to 8.
